# DEMANDE DE BREVET EUROPEEN

(11) **EP 4 765 641 A1**
(43) Date de publication de la demande: **24.06.2026**
(21) Numéro de dépôt: 25224200.3
(22) Date de dépôt: 17.12.2025
(51) Int. Cl.: H03K 17/12, H03K 17/74, H10D 8/60

(54) **DISPOSITIF ÉLECTRONIQUE ET MODULE ÉLECTRONIQUE**

(30) Priorité: 17.12.2024 FR 2414315
(71) Demandeur: Commissariat à l'Energie Atomique et aux Energies Alternatives, 75015 Paris (FR)
(72) Inventeur: PEREZ, Gaëtan, 38054 GRENOBLE Cedex 09 (FR); MASANTE, Cédric, 38054 GRENOBLE Cedex 09 (FR); GODIGNON, Philippe, 38054 GRENOBLE Cedex 09 (FR)
(74) Mandataire: Hautier IP

(57) **Abrégé**

L'invention concerne un dispositif électronique comprenant :
- un composant présentant une résistance (R120) à coefficient de température négatif, et
- un moyen de contrôle de la température présentant une résistance électrique (R130) variant en fonction de la température T de sorte que la somme de la résistance totale (R) soit, sur une deuxième sous-gamme de température (302), supérieure à une température de consigne (305), strictement supérieure à la résistance totale (R) à la température de consigne (305).

## Description

### DOMAINE TECHNIQUE

Le domaine technique de l'invention concerne les dispositifs électroniques tels que ceux pouvant être utilisés dans un circuit électronique pour composants de puissance. Le domaine technique concerne également les assemblages de ces dispositifs sous forme de modules électroniques.

### ÉTAT DE LA TECHNIQUE

Le document [G. Perez et al., « Diamond semiconductor performances in power electronics applications », Diamond and Related Materials, Volume 110, 2020, 108154, ISSN 0925-9635, https://doi.org/10.1016/j.diamond.2020.108154] décrit un composant électronique, en particulier une diode Schottky réalisée à partir d'un matériau semiconducteur à large bande interdite (« WBG » pour « Wide Band Gap » en anglais) et en l'occurrence du diamant, ainsi que les problématiques de mise en parallèle de ce type de composant.

La diode Schottky décrite présente, dans l'état passant, une variation de résistance en fonction de la température non-monotone avec une valeur minimale de résistance pour une température de 640 K. La diode Schottky présente, entre la température ambiante et 640 K, un coefficient de température négatif (dit « CTN » ou « NTC » pour « Negative Temperature Coefficient » en anglais) c'est-à-dire que la résistance décroît en fonction de la température. La diode Schottky présente également, pour une température supérieure à 640 K, un coefficient de température positif (dit « CTP » ou « PTC » pour « Positive Temperature Coefficient » en anglais). Autrement dit, la résistance croît à mesure que la température augmente.

Les auteurs indiquent que le coefficient de température négatif peut donner lieu à un auto-échauffement (« self-heating » dans le document) qui conduit la diode Schottky à augmenter sa température tant que sa résistance décroît, jusqu'à atteindre une température d'équilibre autour de 640 K. Ce phénomène d'auto-échauffement permet ainsi de bénéficier d'une diode Schottky qui, dans son état passant, présente une résistance minimale.

Toutefois, pour certains composants électroniques présentant un coefficient de température négatif, la température d'équilibre peut être trop élevée pour permettre leur intégration. À titre d'exemple, cette température peut être bien supérieure à la température d'endommagement de son boitier de protection. Dès lors, il y a lieu de contrôler la température maximale atteinte par le composant électronique en fonctionnement.

Pour contrôler la température d'un composant à coefficient de température négatif, G. Perez et al. suggèrent de coupler ce dernier à un dissipateur thermique (dit « heat sink » en anglais). De la sorte, la chaleur dissipée par le composant est évacuée et l'auto-échauffement est contrôlé. Les auteurs remarquent toutefois que la taille du dissipateur thermique croit à mesure que la température de fonctionnement visée décroit. De plus, la miniaturisation des composants électroniques est difficilement compatible avec une augmentation de la taille des dissipateurs. Cette solution s'avère donc en pratique limitée.

Il existe donc un besoin de fournir un moyen de contrôler la température d'un composant électronique à coefficient de température négatif.

### RÉSUMÉ

Pour atteindre cet objectif, l'invention prévoit un dispositif électronique comprenant un composant électronique, ledit composant électronique présentant une résistance, ladite résistance présentant, pour une gamme de température, un coefficient de température négatif, ladite gamme de température comprenant une température de consigne divisant ladite gamme de température en deux sous-gammes de température dont :
a. une première sous-gamme de température correspondant aux températures de la gamme de température inférieures ou égales à la température de consigne ; et
b. une deuxième sous-gamme de température correspondant aux températures de la gamme de température strictement supérieures à la température de consigne.

Le dispositif électronique est remarquable en ce qu'il comprend une thermistance, électriquement connectée en série avec le composant électronique et couplée thermiquement au composant électronique, la thermistance présentant une résistance électrique variant en fonction de la température de sorte que la résistance électrique totale du dispositif électronique, comprenant la somme de la résistance électrique du composant électronique et de la résistance électrique de la thermistance soit, sur la deuxième sous-gamme de température, strictement supérieure à la résistance électrique totale à la température de consigne.

Par « éléments couplés thermiquement », on entend que la résistance thermique du couplage entre les éléments est inférieure ou égal à 1 K/W.

Par « thermistance », on attend tout type d'élément qui a une résistance avec un coefficient de température positif. Il s'agit par exemple d'une thermistance en tant que telle, une thermo-résistance ou encore un semiconducteur avec une résistance qui augmente en fonction de la température.

Le composant électronique (que l'on peut appeler plus simplement « composant ») mis en œuvre est par exemple un composant électronique tel que décrit par le document de G. Perez et al. et présenté plus haut. La thermistance, connectée en série au composant, permet d'ajouter une résistance variable en fonction de la température dans le chemin du courant passant dans le composant. Une augmentation de la résistance de la thermistance permet ainsi de limiter le courant passant dans le composant et donc de limiter l'échauffement associé à la circulation de ce courant dans le composant.

En particulier, grâce à l'augmentation de la résistance totale au-delà de la température de consigne, une dichotomie s'opère autour de la température de consigne. De la sorte, le courant circulant dans le composant est limité lorsque sa température dépasse la température de consigne et son échauffement est par conséquent également limité. L'auto-échauffement associé au coefficient de température négatif du composant est donc limité, voire évité, et la température du composant est maintenue au voisinage de la température de consigne.

Le caractère passif de la thermistance permet une conception et une mise en œuvre simplifiées du composant électronique. **Il** n'est pas nécessaire d'apporter une énergie supplémentaire pour alimenter la thermistance. Les caractéristiques de la thermistance sont dimensionnées lors de sa fabrication. Les opérations de maintenance sont également simplifiées car il n'est pas nécessaire d'étalonner ou recalibrer la thermistance. Ainsi le dispositif électronique peut être utilisé suivant une approche dite, en anglais, « set and forget », qui se traduit par « monter (ou assembler) et oublier ».

Avantageusement, la résistance électrique de la thermistance est telle que la résistance totale du dispositif est croissante sur la deuxième sous-gamme.

Avantageusement, la résistance électrique de la thermistance sur la deuxième sous-gamme de température est strictement supérieure à la résistance électrique du composant électronique à la température de consigne.

Avantageusement, la résistance électrique de la thermistance sur la première sous-gamme de température est constante ou croissante.

Avantageusement, la résistance électrique de la thermistance sur la première sous-gamme de température est inférieure ou égale à 10% de la résistance électrique du composant électronique à la température de consigne.

Avantageusement, la résistance thermique du couplage thermique entre la thermistance et le composant électronique est inférieure ou égale à 0,01 K/W.

Avantageusement, la thermistance est collée ou soudée ou brasée ou frittée sur le composant électronique.

Alternativement, le composant électronique et la thermistance sont réalisés dans une même pièce, par exemple à partir d'un même substrat ou d'un même empilement de couches.

Avantageusement, le dispositif électronique comprend une semelle électriquement et thermiquement conductrice, le composant électronique étant collé ou soudé ou brasé ou fritté sur la semelle et la thermistance étant collée ou soudée ou brasée ou frittée sur la semelle.

Avantageusement, le composant est réalisé à partir de diamant.

Dans les solutions existantes, la mise en parallèle de composants à coefficient de température négatif peut favoriser, voire accélérer, l'auto-échauffement, voire l'emballement thermique, des composants électroniques, même si ces derniers sont censés être identiques. En effet, il existe toujours des disparités de fabrication, même faibles, qui font que ces composants électroniques sont différents, même légèrement. La circulation d'un courant électrique dans chacun des composants selon l'art antérieur amorce un auto-échauffement de chaque composant. Or, les disparités de fabrication vont entraîner un échauffement un plus important dans l'un des composants. La réduction de résistance causée par l'auto-échauffement focalise le courant électrique sur le composant sujet à l'auto-échauffement. L'autre composant voit un courant électrique réduit, ce qui peut avoir tendance à refroidir ou limiter l'échauffement de ce dernier (et augmenter sa résistance dans le cas d'un dispositif CTN). Le courant électrique est alors fortement dévié vers l'un des composants qui peut être endommagé (directement ou bien son environnement d'intégration) ou vieillir de manière accélérée. Ceci est problématique dans le cas de la mise en parallèle de deux composants à coefficient de température négatif. Ceci est particulièrement problématique lorsque ces composants sont intégrés dans un circuit pour électronique de puissance. En effet, le courant dans un circuit pour électronique de puissance est généralement imposé par la charge dudit circuit. Les composants ne peuvent donc pas moduler le courant circulant dans le circuit pour limiter l'échauffement. Ils doivent se partager le courant de manière équitable.

Pour résoudre ce problème, l'invention prévoit également un module électronique comprenant :
a. un dispositif électronique selon l'invention ; et
b. un ou plusieurs dispositifs électroniques supplémentaires, connectés en parallèle dudit dispositif électronique.

La mise en parallèle d'un dispositif selon l'invention avec un autre dispositif électronique (qui n'est pas forcément un dispositif selon l'invention ou un composant présentant une résistance à coefficient négatif de température) pour former un module permet de contrôler l'auto-échauffement du dispositif électronique pour limiter la déviation du courant. Dès lors, le module selon l'invention ne risque pas de souffrir d'un endommagement ou d'un vieillissement accéléré.

Avantageusement, le dispositif électronique et ledit au moins un dispositif électronique supplémentaire sont couplés thermiquement.

Avantageusement, le module électronique est un module électronique de puissance, au moins l'un des dispositifs électroniques, parmi le dispositif électronique et ledit au moins un dispositif électronique supplémentaire, est réalisé à partir de diamant.

Dans un mode de réalisation, particulièrement avantageux, ledit au moins un dispositif électronique supplémentaire est également un dispositif électronique selon l'invention. De la sorte, chacun des dispositifs selon l'invention œuvre pour limiter l'auto-échauffement d'un seul composant et la dérivation du courant vers ce seul composant.

### BRÈVE DESCRIPTION DES FIGURES

La figure 1 représente un résultat de simulation numérique pour un composant électrique selon l'art antérieur, ledit composant électronique présentant un coefficient de température négatif pour une gamme de température.
Les figures 2 et 3 représentent des premier et deuxième résultats de simulation numérique pour un dispositif électronique selon l'invention.
La figure 4 représente, schématiquement, un premier mode de réalisation d'un dispositif électronique selon l'invention, ledit dispositif électronique étant présenté sans et avec son boîtier de protection.
La figure 5 représente, schématiquement, un deuxième mode de mise en œuvre du dispositif électronique selon l'invention, ledit dispositif électronique étant également représenté sans et avec son boîtier de protection.
La figure 6 représente un exemple de schéma électrique équivalent d'un module électronique selon l'invention.
Les figures 7 et 8 représentent des premier et deuxième résultats de simulation numérique pour des modules électroniques selon l'art antérieur et selon l'invention.
La figure 9 représente, schématiquement, un premier mode de réalisation d'un module électronique selon l'invention, ledit module électronique étant représenté sans et avec son boîtier de protection.
La figure 10 représente, schématiquement, un deuxième mode de mise en œuvre du module électronique selon l'invention.

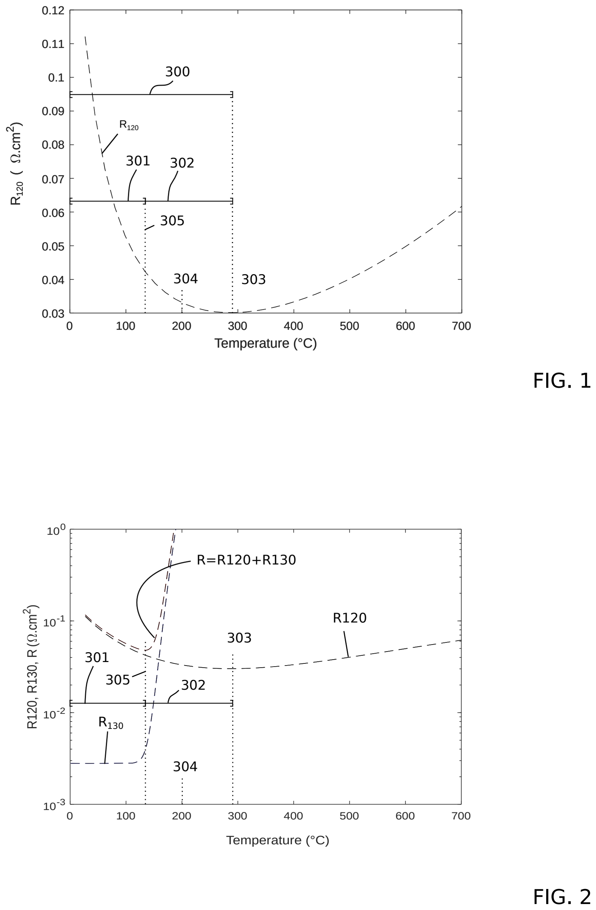

Les figures sont données à titre d'exemples et ne sont pas limitatives de l'invention. Elles constituent des représentations schématiques de principe destinées à faciliter la compréhension de l'invention et ne sont pas nécessairement à l'échelle des applications pratiques. En particulier, les figures 1 à 10 ne sont pas représentatives de la réalité.

### DESCRIPTION DÉTAILLÉE

L'invention vise à limiter l'auto-échauffement de composants électroniques 120. Cette invention s'inscrit avantageusement dans le domaine des dispositifs adaptés à l'électronique de puissance puisqu'il s'agit d'un domaine pour lequel les températures des composants peuvent être très élevées.

Un dispositif électronique 100 selon l'invention comprend un composant électronique 120. Il s'agit par exemple d'un composant selon l'art antérieur tel qu'une jonction formant une diode ou un transistor. Plus particulièrement, il peut s'agir d'une diode Schottky réalisée à partir de diamant.

Le composant 120 est particulier en ce qu'il présente, pour une gamme de température 300 particulière, une résistance électrique R120 à coefficient de température négatif. On appelle par « coefficient de température négatif » un élément dont la résistance varie négativement en fonction de la température (à noter que par « variation », on entend une variation continue d'une valeur, par exemple de résistance ou de température). Un tel élément est, en l'absence de tout moyen de contrôle, susceptible d'être sujet à un auto-échauffement, pouvant amener dans certains cas à un emballement thermique.

Le dispositif électronique 100 selon l'invention est justement remarquable en ce qu'il adjoint une thermistance 130 au composant 120. Cette thermistance 130 est configurée pour limiter l'auto-échauffement du composant 120.

Les figures 1 et 2 représentent des résultats de simulation d'un dispositif 100 selon l'invention. La figure 1 représente un résultat pour un dispositif où la thermistance 130 est absente. En d'autres termes, la figure 1 représente le comportement du composant 120 seul. Ce résultat correspond par exemple à un comportement observable sur un composant électronique selon l'art antérieur. La discussion du comportement du composant 120 seul permet de mesurer ensuite le bénéfice de l'adjonction de la thermistance 130.

La figure 2 représente un résultat de simulation pour le même dispositif 100 à ceci près que l'effet de la thermistance 130 est pris en compte.

Dans les figures 1 et 2, le composant 120 est modélisé par une diode Schottky réalisée à partir de diamant. Le diamant est particulier en ce qu'il présente une résistance à coefficient de température négatif. D'autres modèles auraient pu être utilisés pour le composant 120, tels qu'une diode en Nitrure d'Aluminium (qui présente également un coefficient de température négatif) ou une jonction de transistor à base de diamant ou d'AIN. Les résultats des figures 1 et 2 sont obtenus lorsque le composant 120 est dans un état passant.

De manière générale, le composant 120 est préférentiellement un composant à conduction unipolaire. Il est par exemple réalisé à partir d'un matériau semiconducteur unipolaire. **Il** s'agit par exemple de diamant ou de nitrure d'aluminium, tel que précité. Il peut également s'agir de GaN ou de Ga2O3. Par « à partir d'un matériau », on entend qu'il comprend ledit matériau et éventuellement d'autres matériaux.

Dans un matériau semiconducteur unipolaire, la conduction électrique est dominée par un seul type de porteur de charge, à savoir les électrons ou les trous. À l'inverse, dans un matériau semiconducteur bipolaire, tel que le silicium, la conduction est assurée par les deux types de porteurs de charge en même temps. Les composants unipolaires présentent de nombreux avantages. Par exemple, la limitation à un seul type de porteur de charge permet une commutation plus rapide des composants. Ces composants montrent également un efficacité énergétique améliorée par rapport à leurs homologues bipolaires. On note que les composants unipolaires sont également généralement plus simples à concevoir et à fabriquer que les composants bipolaires.

Dans la figure 2, la thermistance 130, aussi appelée « thermo-résistance », est modélisée par une résistance R130 dont la température varie en fonction de la température.

La thermistance 130 est électriquement connectée en série avec le composant 120. De la sorte, elle est parcourue par le courant circulant dans le composant 120. De plus, elle peut limiter le courant circulant dans les deux éléments 120, 130. La thermistance 130 est également couplée thermiquement avec le composant 120 de sorte que la température de la thermistance 130 soit proche de, sinon égale à, la température du composant 120. Par « proche », on entend égal à 10% près, voire à 5% près. Le couplage thermique entre les deux éléments 120, 130 est modélisé par une résistance thermique inférieure ou égale à 1 K/W. De la sorte l'augmentation de température du composant 120 se répercute sur la thermistance 130. Une résistance thermique inférieure ou égale à 1 K/W est généralement assez faible pour garantir un équilibre thermique constant. Une résistance thermique inférieure, par exemple inférieure ou égale à 0,01 K/W, peut toutefois être préférée.

La figure 1 représente la résistance R120 mesurée aux bornes du composant 120 en fonction de la température. Elle présente une forme parabolique avec un minimum autour d'une température 303, que l'on nommera « température d'équilibre », d'environ 300°C. Il s'agit d'une température autour de laquelle le mécanisme menant à l'auto-échauffement du composant tend à se stabiliser. Bien entendu, la température réelle du composant 120 peut déprendre de facteurs complémentaires, tels que les pertes par effet Joule du composant 120, ou encore le couplage thermique avec un dissipateur thermique (ou un bain thermique). Pour une gamme de température inférieure à la température d'équilibre 303, la résistance R120 décroît en fonction de la température (autrement dit elle présente une pente négative en fonction de la température).

Ainsi, le composant 120 présente un coefficient de température négatif sur une gamme de température 300 inférieure à la température d'équilibre 303. Ainsi, en dehors de toute régulation de courant ou de toute régulation thermique, le composant 120, soumis à un courant électrique, est susceptible de subir un auto-échauffement jusqu'à atteindre une résistance électrique R120 minimale et une température d'équilibre 303.

Au-delà de la température d'équilibre 303, la résistance R120 croît en fonction de la température. Autrement dit, le composant 120 présente un coefficient de température positif sur une autre gamme de température, supérieure à la température d'équilibre.

Un exemple de température 304 dite « maximale » est montré dans la figure 1. Il s'agit par exemple d'une température que le composant 120 ne doit pas dépasser. Il peut s'agir d'une température à laquelle un endommagement peut se produire ou une température maximale supportée par un boîtier de protection 160. Afin de se prémunir de toute détérioration, une température dite « de consigne » 305 peut être établie. Il s'agit d'une température de fonctionnement souhaitée du composant 120. Cette température de consigne 305 est par exemple déterminée à partir de la température maximale 304 et éventuellement d'une marge de température.

La gamme de température 300 sur laquelle le composant 120 montre un coefficient de température négatif comprend donc la température maximale 304 et la température de consigne 305. La température de consigne 305 divise la gamme de température 300 en deux sous-gammes de température 301, 302 :
a. une première sous-gamme de température 301 comprenant toutes les températures de la gamme de température 300 qui sont inférieures ou égales à la température de consigne 305 ; et
b. une deuxième sous-gamme de température 302 comprenant toutes les températures de la gamme de température 300 qui sont strictement supérieures à la température de consigne 305.

La figure 2 montre l'effet de la thermistance 130 sur le comportement thermique du dispositif 100. La résistance R120 du composant 120, illustrée en figure 1, est reportée dans la figure 2 pour permettre la comparaison. La résistance R130 de la thermistance 130 seule est également reportée sur la figure 2 pour montrer le mécanisme de contrôle de la température. La résistance du dispositif 100 (vue par le courant circulant dans le composant 120 et la thermistance 130) correspond à la résistance notée « R » dans la figure 2 et est égale à la somme des résistances R120, R130 précitées.

La résistance R130 de la thermistance 130 est choisie pour varier en fonction de la température de sorte que la résistance totale R sur la deuxième sous-gamme de température 302 soit strictement supérieure à la résistance totale R à la température de consigne 305. La résistance totale R ne montre plus un coefficient de température négatif sur toute la gamme de température 300. Si elle peut montrer un coefficient de température négatif sur la première sous-gamme 301, elle montre en revanche un coefficient de température positif sur la deuxième sous-gamme 302. L'auto-échauffement est donc susceptible de ne pas se produire sur la deuxième sous-gamme 302 qui, pour rappel, comprend la température maximale 304. La température de consigne 305 devient une nouvelle température d'équilibre du dispositif 100.

Lors de l'auto-échauffement, il peut y avoir une inertie thermique qui peut agir et augmenter temporairement la température du composant 120. Toutefois, pour peu que la marge entre la température de consigne 305 et la température maximale 304 soit suffisante, la température du composant 120 n'atteint pas la température maximale 304. À terme, la température du dispositif 100 (et donc du composant 120) fini par se stabiliser au voisinage de la température de consigne 305.

Dans la figure 2, la résistance R130 de la thermistance 130 est croissante sur la deuxième sous-gamme de température 302. Autrement dit, elle est à coefficient de température positif sur cette deuxième sous-gamme de température 302. La pente de la résistance R130 est alors choisie de sorte à former, autour de la température de consigne 305, un minimum local de résistance totale R. Plus forte est la pente de la résistance R130 et meilleure sont l'atténuation de l'auto-échauffement sur la deuxième sous-gamme 302 et le contrôle de la température du composant 120. Dans l'exemple illustré, la résistance R130 de la thermistance 130 est monotone. Elle pourrait toutefois être non-monotone en permettant préférentiellement toujours la formation d'un minimum local de résistance R autour de la température de consigne 305.

Dans l'exemple de la figure 2, la résistance R130 de la thermistance 130 présente, sur la première sous-gamme 301, une résistance R130 faible devant la résistance R120 sur la même sous-gamme 301. La résistance électrique R130 de la thermistance 130 sur la première sous-gamme 301 est par exemple inférieure ou égale à 10% de la résistance électrique R120 du composant 120 sur cette sous-gamme 301. De la sorte, les pertes induites par la présence de la thermistance 130 sur le chemin électrique sont faibles voire négligeable.

La résistance R130 de la thermistance 130 peut être constante sur la première sous-gamme 1 (telle qu'illustrée dans la figure 2) ou croissante. Dans ce dernier cas, elle est alors à coefficient de température positif sur la première sous-gamme 301. La résistance R130 de la thermistance 130 peut également être décroissante sur cette sous-gamme 301 pour peu qu'elle reste préférentiellement inférieure à ou égale à 10% de la résistance électrique R120 du composant 120 sur cette sous-gamme 301. Dans un mode de réalisation, la résistance R130 de la thermistance 130 est croissante sur les première et deuxième sous-gammes 301, 302. Autrement dit, elle est à coefficient positif de température sur toute la gamme de température.

Dans l'exemple de la figure 2, la résistance R130 de la thermistance 130 montre une augmentation de résistance R130 à partir d'une température seuil. Cette température seuil est inférieure à la température de consigne 305. Toutefois, plus la pente de la résistance R130 de la thermistance 130 est élevée sur la deuxième sous-gamme de température 302 et plus faible et la différence entre la température seuil sur moyen de contrôle 130 et la température de consigne 305.

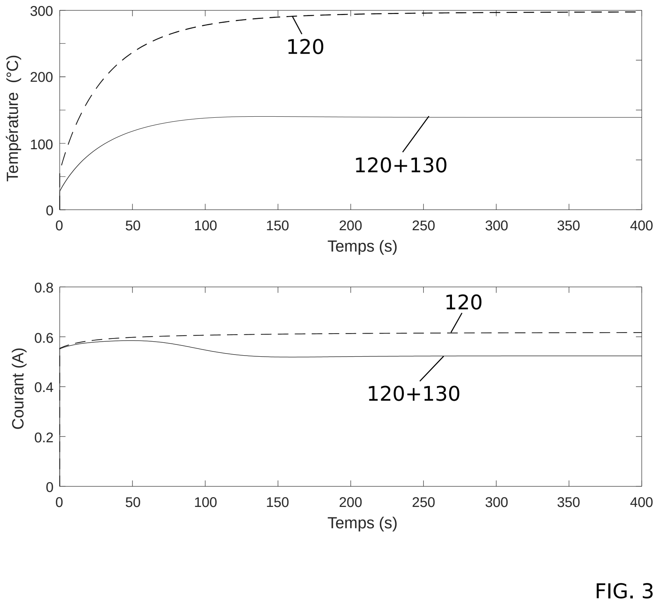

La figure 3 représente deux résultats de simulation numériques obtenus à partir des dispositifs 100 de la figure 1 et de la figure 2. En particulier, ces résultats illustrent, en fonction du temps, la température et le courant circulant dans le composant 120 sans thermistance 130 (cas de la figure 1) et avec thermistance 130 (cas de la figure 2). On observe alors une réduction de la température grâce au moyen de contrôle 130 de la température. La réduction de température est notamment due à la réduction de courant visible sur le deuxième graphique où l'effet de la thermistance 130 est de limiter le courant totale circulant dans le composant 120.

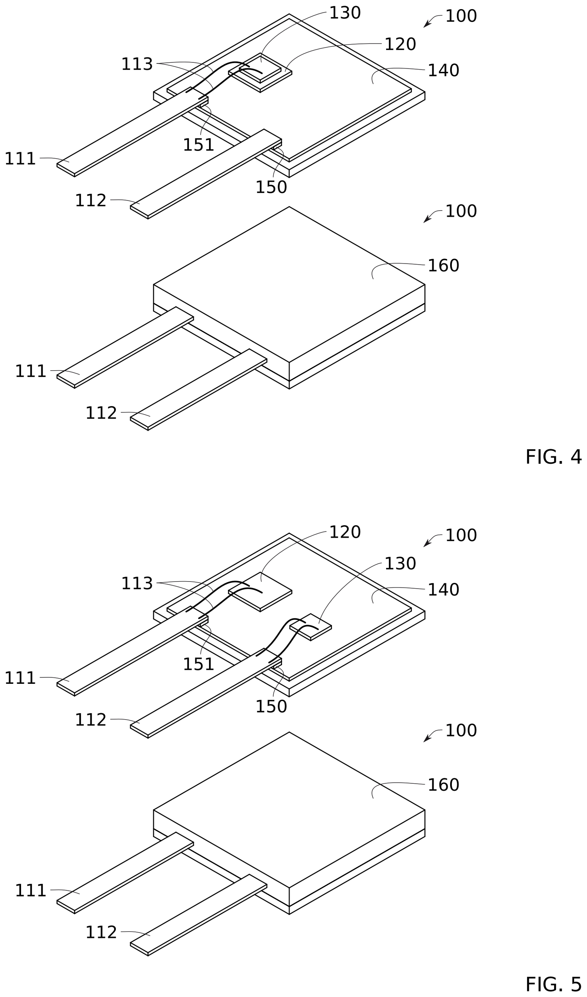

La figure 4 représente, schématiquement, un premier mode de réalisation d'un dispositif électronique 100 selon l'invention. Le dispositif électronique 100 est présenté, à gauche sur la figure, sans son boîtier de protection 160 et, à droite sur la figure, avec son boîtier de protection 160.

Dans ce mode de réalisation, le composant 120 est un empilement de couches formant par exemple une jonction Schottky. Ledit empilement de couches comprend par exemple une couche semiconductrice à base de diamant et une couche métallique. Dans cet exemple, la thermistance 130 est assemblée directement sur le composant 120. Elle est par exemple collée sur l'anode ou la cathode du composant 120 au moyen d'une colle électriquement et thermiquement conductrice. Un tel assemblage peut être qualifié de « monolithique ». Ce mode de réalisation à l'avantage de fournir une bonne connexion électrique et un bon couplage thermique (c'est-à-dire présentant une résistance thermique inférieure à 0,01 K/W). La thermistance 130 peut également être brasée ou soudée ou frittée sur le composant 120 (sur l'anode ou la cathode) pour offrir un meilleur couplage thermique et un meilleur contact électrique.

Le dispositif 100 peut comprendre également deux électrodes conductrices 111, 112. Ces électrodes 111, 112 forment par exemple des pattes de contact (dites « pins » en anglais »). Le composant 120 et la thermistance 130 sont connectés en série entre ces deux électrodes conductrices 111, 112. La thermistance 130 est par exemple connectée en série entre le composant 120 et l'une des deux électrodes conductrices 111, 112.

Le dispositif 100 peut en outre comprendre un substrat 140, pouvant être également appelé « semelle », sur lequel l'ensemble, comprenant le composant 120 et la thermistance 130, est fixé. Le composant 120 ou la thermistance 130 sont par exemple collés ou soudés ou brasés ou frittés sur la semelle 140. La semelle 140 peut être conductrice, permettant ainsi de connecter l'ensemble comprenant le composant 120 et la thermistance 130 à l'une des deux électrodes conductrices 111, 112. Pour cela, un contact électrique 150, et préférentiellement mécanique, peut être établi entre la semelle 140 et l'une des deux électrodes 112.

L'ensemble comprenant le composant 120 et la thermistance 130 peut être connecté à l'autre électrode conductrice 111 au moyen de fils de pontage dit également « wire bonding » en anglais. Le ou les fils de pontage connectent alors ladite électrode conductrice 111 avec le composant 120 (si c'est la thermistance 130 qui est connectée à la semelle 140) ou avec la thermistance 130 (si c'est le composant 120 qui est connecté à la semelle). L'électrode conductrice 111 connectée au moyen du ou des fils de pontage peut être fixée à la semelle 140 au moyen d'un contact mécanique 151 électriquement isolant. Ainsi, la semelle 140 ne court-circuite pas le composant 120.

Le dispositif 100 peut comprendre un boîtier 160, prenant par exemple appui sur la semelle 140 et enrobant l'ensemble comprenant le composant 120 et la thermistance 130.

Le dispositif 100 de la figure 5 diffère du dispositif 100 de la figure 4 en ce que le composant 120 et la thermistance 130 ne sont pas en contact direct. Ils sont connectés électriquement et couplés thermiquement au moyen de la semelle 140. Pour cela, la semelle 140 est avantageusement électriquement conductrice et thermiquement conductrice.

Le composant 120 est par exemple directement collé ou soudé ou brasé ou fritté sur la semelle 140. La thermistance 130 peut également être directement collée ou soudée ou brasée ou frittée sur la semelle 140. La distance entre les deux éléments 120, 130 est telle que le couplage thermique présente une résistance thermique inférieure à 1 K/W et préférentiellement inférieur à 0,01 K/W. Pour ne pas court-circuiter le composant 120 ou la thermistance 130, les électrodes conductrices 111, 112 sont électriquement isolé de la semelle 140. Elles peuvent être fixées au moyen de contacts mécaniques 150, 151 électriquement isolants. Le composant 120 peut alors être connecté à l'une des électrodes 111 au moyen de fils de pontage 113. La thermistance 130 peut être fixée à l'autre électrode 112 au moyen de fils de pontage supplémentaires. Ce mode de réalisation du dispositif 100 à l'avantage d'être simple à réaliser car le composant 120 et la thermistance 130 peuvent être montés indépendamment l'un de l'autre.

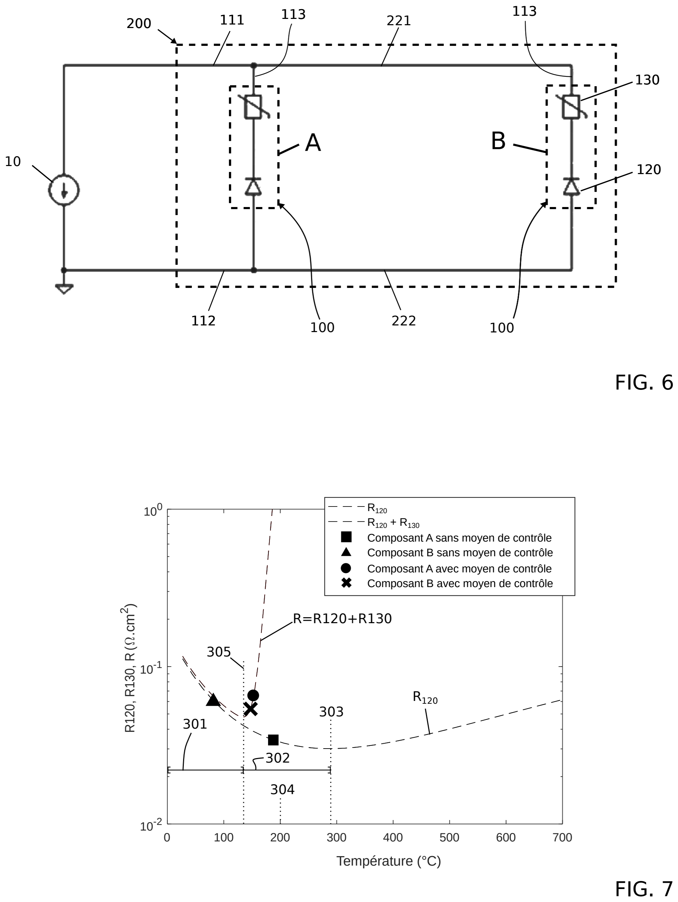

Les figures 6 à 8 représentent une mise en parallèles de deux dispositifs 100 selon l'invention formant un module électronique 200. Les deux dispositifs 100 selon l'invention, même s'ils sont de même catégorie, sont différenciés par les lettres A et B.

La figures 6 représente schématiquement un mode de réalisation d'un module 200, ainsi que les deux dispositifs A, B qu'il comprend. Le module 200 est connecté à une source de courant 10. Les dispositifs A, B sont connectés en parallèle dans le module 200. Ainsi, le courant électrique délivré par la source 10 est distribué sur chaque dispositif A, B. Le principe reste le même si la source de courant 10 est remplacée par une source de tension. Dans ce cas, le courant circulant dans le module est imposé par les dispositifs 100, le courant se répartissant entre les dispositifs 100 en parallèle.

En l'absence des thermistances 130, l'auto-échauffement d'un des deux composants 120 peut prendre le dessus et drainer une grande partie, voire la totalité, du courant délivré par la source de courant 10. Il en résulte l'échauffement du composant 120 pouvant mener à un emballement thermique et/ou une détérioration ou, à minima, un vieillissement précoce.

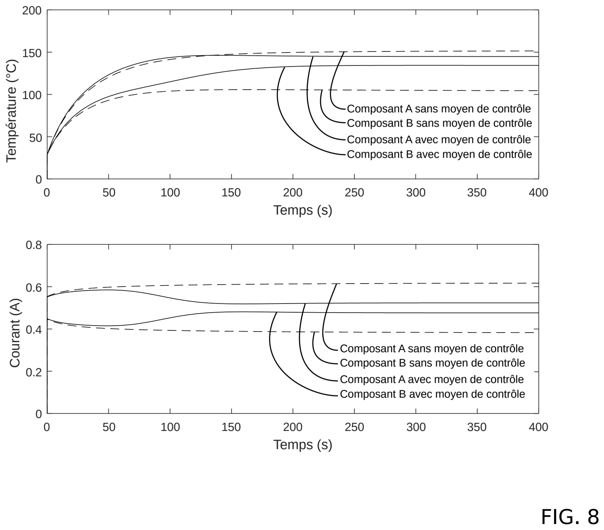

L'effet des thermistances 130 des dispositifs A et B est décrit en référence aux figures 7 et 8. Ces figures représentent des résultats de simulations pour un exemple de module 200 selon l'invention. Les dispositifs A, B sont de même catégorie et sont censé être identiques. Ces dispositifs A, B montrent toutefois de légères déviation dans leurs propriétés. Le dispositif A présente par exemple une résistance légèrement inférieure à celle du dispositif B. La figure 6 représente, pour chaque dispositif A, B, et de la même façon que la figure 2, l'état dudit dispositif A, B lorsque la thermistance 130 est prise en compte ou non.

Par exemple, en l'absence de moyen de contrôle 130, le dispositif A (représenté par le carré) subit un auto-échauffement et réduit sa résistance jusqu'à atteindre environ 200°C. Le dispositif A draine une grande partie du courant électrique induit un auto-échauffement moindre du dispositif B (représenté par le triangle). Dans la simulation donnant lieu au résultat de la figure 7, les dispositifs A et B sont thermalisés par un bain thermique, ce qui permet de limiter la température atteinte par le dispositif A. Toutefois, sans thermalisation suffisante, le dispositif A est alors susceptible d'entraîner une augmentation de température plus importante et donc de subir une détérioration ou un vieillissement précoce.

En prenant en compte les thermistances 130, chaque dispositif A, B va ajuster sa résistance pour lutter contre le phénomène de focalisation de courant afin de conserver une répartition équitable du courant. Dès lors, aucun des dispositifs A, B (représentés par le cercle et la croix) ne subit un emballement thermique.

L'effet des thermistances 130 sur chaque dispositif A, B est également illustré par la figure 8 qui représente la température et le courant circulant dans les dispositifs A et B lorsque la thermistance 130 est désactivée et lorsqu'elle est activée. Les températures des deux dispositifs A, B sont proches lorsque les thermistances 130 sont actives. La température de chacun des dispositifs A et B légèrement supérieure à la température de consigne 305, car le courant délivré par la source 10 échauffe fortement les dispositifs. Toutefois, grâce aux thermistances 130, l'auto-échauffement est contenu. Les températures des dispositifs A, B sont plus proches montrant une meilleure répartition du courant délivré par la source 10 entre les deux dispositifs A et B. Le module 200 selon l'invention est donc moins susceptible de détérioration ou d'un vieillissement précoce.

La figure 8 montre une meilleure répartition des températures entre les deux dispositifs A, B lorsque les thermistances entrent en jeu. Les courants électrique circulant dans les deux dispositifs A, B sont également plus proches.

Selon un développement, le module 200 peut comprendre au moins trois dispositifs 100 connectés en parallèle. Le principe de répartition des températures s'applique alors avantageusement à ce développement.

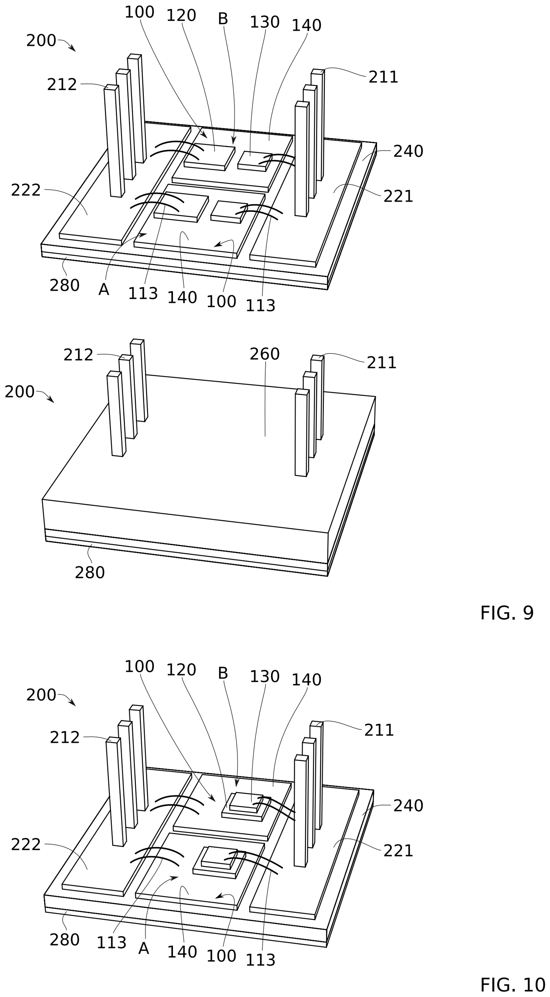

La figure 9 représente, schématiquement, un premier mode de réalisation d'un module électronique 200 selon l'invention. Le module 200 est présenté, à gauche sur la figure, sans son boîtier de protection 260 et, à droite sur la figure, avec son boîtier de protection 260.

Dans ce mode de réalisation, les dispositifs 100 sont électriquement connectés en parallèle. Pour chaque dispositif 100, l'ensemble comprenant le composant 120 et la thermistance 130 est électriquement et thermiquement connecté au moyen de la semelle 140 électriquement et thermiquement conductrice. Ce mode de réalisation est similaire au mode de réalisation de la figure 4. Les semelles de deux dispositifs A, B sont distantes l'une de l'autre pour éviter tout contact électrique et donc tout court-circuit.

Les dispositifs A, B sont connectés en parallèle au moyen de pistes métalliques 221, 222, par exemple en cuivre, également nommées « busbar » en anglais. Chaque dispositif A, B est par exemple connecté entre les deux busbars 221, 222 au moyen de fils de pontage 113.

Le module 200 peut également comprendre deux électrodes conductrices ou deux groupes d'électrodes conductrices 211, 212 formants les pattes de contact du module 200. Chaque busbar 221, 222 peut alors être connecté à l'un ou l'autre des groupes d'électrodes conductrices 221, 222. Le module 200 peut également comprendre un support 240 contre lequel peuvent s'étendre les busbars 221, 222 et les dispositifs A, B (par exemple par l'intermédiaire de leurs semelles 140).

Le module 200 peut également comprendre une plaque thermiquement conductrice 280 permettant d'homogénéiser la température au sein du module. Ceci permet de limiter la dispersion en température et en courant des dispositifs électroniques 100. Cette plaque thermiquement conductrice 280 peut être couplée thermiquement avec le support 240. Elle peut également être couplée thermiquement avec un dissipateur thermique.

Le module 200 de la figure 10 diffère du module de la figure 9 en ce que le composant 120 et la thermistance de chaque dispositif A, B forme un ensemble monolithique, similaire à ce qui est présenté en figure 4. Dans ce mode de réalisation, les composants 120 et les thermistances sont en contact direct. Ainsi, il n'est plus nécessaire que les semelles de chaque dispositif A, B soient distinctes. Elles peuvent être confondues pour former une seule et unique semelle. Ceci permet de coupler thermiquement les dispositifs 100 entre eux. Lorsque les dispositifs sont identiques, cela permet de réduire davantage l'écart de température entre les composants 120 des deux dispositifs, afin de réduire davantage la dispersion en courant et en température des dispositifs 100.

L'invention n'est pas limitée aux modes de réalisations précédemment décrits et s'étend à tous les modes de réalisation couverts par l'invention.

## Revendications

1. Dispositif électronique (100) comprenant un composant (120) électronique, ledit composant électronique (120) présentant une résistance (R120), ladite résistance (R120) présentant, pour une gamme de température (300), un coefficient de température négatif, ladite gamme de température (300) comprenant une température de consigne (305) divisant ladite gamme de température en deux sous-gammes de température dont :
• une première sous-gamme de température (301) correspondant aux températures de la gamme de température (300) inférieures ou égales à la température de consigne (305) ; et
• une deuxième sous-gamme de température (302) correspondant aux températures de la gamme de température (300) strictement supérieures à la température de consigne (305),
le dispositif électronique étant **caractérisé en ce qu'**il comprend une thermistance (130), électriquement connectée en série avec le composant électronique (120) et couplée thermiquement au composant électronique (120), la thermistance (130) comprenant une résistance électrique (R130) variant en fonction de la température de sorte que la résistance électrique totale (R) du dispositif électronique (100), comprenant la somme de la résistance électrique (R120) du composant électronique (120) et de la résistance électrique (R130) de la thermistance (130) soit, sur la deuxième sous-gamme de température (302), strictement supérieure à la résistance électrique totale (R) à la température de consigne (305).

2. Dispositif électronique (100) selon la revendication précédente, dans lequel la résistance électrique (R130) de la thermistance (130) est telle que la résistance totale (R) du dispositif (100) est croissante sur la deuxième sous-gamme (302).

3. Dispositif électronique (100) selon l'une des revendications précédentes, dans lequel la résistance électrique (R130) de la thermistance (130) sur la deuxième sous-gamme de température (302) est strictement supérieure à la résistance électrique (R120) du composant électronique (120) à la température de consigne (305).

4. Dispositif électronique (100) selon l'une des revendications précédentes, dans lequel la résistance électrique (R130) de la thermistance (130) sur la première sous-gamme de température (301) est constante ou croissante.

5. Dispositif électronique (100) selon l'une des revendications précédentes, dans lequel la résistance électrique (R130) de la thermistance (130) sur la première sous-gamme de température (301) est inférieure ou égale à 10% de la résistance électrique (R120) du composant électronique (120) à la température de consigne (305).

6. Dispositif électronique (100) selon l'une des revendications précédentes, dans lequel la résistance thermique du couplage thermique entre la thermistance (130) et le composant électronique (120) est inférieure ou égale à 0,01 K/W.

7. Dispositif électronique (100) selon l'une des revendications 1 à 6, dans lequel la thermistance (130) est collée ou soudée ou brasée ou frittée sur le composant (120).

8. Dispositif électronique (100) selon l'une des revendications 1 à 6, dans lequel le composant électronique (120) et la thermistance (130) sont réalisés dans une même pièce.

9. Dispositif électronique (100) selon l'une des revendications précédentes, comprenant une semelle (140) électriquement et thermiquement conductrice, le composant (120) étant collé ou soudé ou brasé ou fritté sur la semelle (140) et la thermistance (130) étant collée ou soudée ou brasée ou frittée sur la semelle (140).

10. Dispositif électronique (100) selon l'une des revendications précédentes, dans lequel le composant (120) est à conduction unipolaire, préférentiellement réalisé à partir de diamant, de AIN, de GaN, ou de Ga₂O₃.

11. Module électronique (200) comprenant :
• un dispositif électronique (100) selon l'une des revendications 1 à 10 ; et
• au moins un dispositif électronique supplémentaire, connecté en parallèle dudit dispositif électronique (100).

12. Module électronique (200) selon la revendication 11, dans lequel le dispositif électronique (100) et ledit au moins un dispositif électronique supplémentaire sont couplés thermiquement.

13. Module électronique (200) selon l'une des revendication 11 ou 12, dans lequel ledit au moins un dispositif électronique supplémentaire (100) est un dispositif électronique (100) selon l'une des revendications 1 à 10.

14. Module électronique (200) selon l'une des revendications 11 à 13, dans lequel le module électronique (200) est un module électronique de puissance, et dans lequel au moins l'un des dispositifs, parmi le dispositif électronique (100) et ledit au moins un dispositif électronique supplémentaire, est réalisé à partir de diamant.
